# EUROPÄISCHE PATENTSCHRIFT

(11) **EP 1 230 500 B1**
(45) Veröffentlichungstag und Bekanntmachung des Hinweises auf die Patenterteilung: **21.01.2004**
(21) Anmeldenummer: 00974528.2
(22) Anmeldetag: 14.11.2000
(51) Int. Cl.: F16H 61/00, H05K 7/00

(54) **AUTOMATIKGETRIEBE EINES KRAFTFAHRZEUGES MIT ELEKTRISCHER STECKVERBINDUNG**
AUTOMATIC TRANSMISSION OF A MOTOR VEHICLE WITH ELECTRICAL PLUG-IN CONNECTION
BOITE AUTOMATIQUE D'UN VEHICULE AVEC CONNEXION A FICHE ELECTRIQUE

(30) Priorität: 18.11.1999 DE 19955437
(43) Veröffentlichungstag der Anmeldung: 14.08.2002
(73) Patentinhaber: ZF FRIEDRICHSHAFEN Aktiengesellschaft, 88038 Friedrichshafen (DE)
(72) Erfinder: BEK, Manfred, 88069 Tettnang (DE)
(86) Internationale Anmeldenummer: PCT/EP2000/011211
(87) Internationale Veröffentlichungsnummer: WO 2001/036847

(56) Entgegenhaltungen:
- EP-A- 0 758 726
- DE-C- 19 751 095
- DE-U- 9 307 228

## Beschreibung

Die Erfindung betrifft ein Automatgetriebe eines Kraftfahrzeuges mit einer elektrischen Steckverbindung zur Übertragung der zur Steuerung des hydraulischen Steuergeräts erforderlichen Signale von einem außerhalb des Getriebes vorgesehenen elektronischen Steuergerät, nach dem Oberbegriff des Anspruchs 1, und wie aus der gattungsbildenden DE 93 07 228 U bekannt.

Insbesondere bezieht sich die Erfindung auf die elektrische Steckverbindung für ein elektrohydraulisches Automatgetriebe, das üblicherweise aus einer Anfahreinheit, z. B. einem hydrodynamischen Wandler, Kupplungen und Bremsen, einem Hydrauliksteuergerät und einem elektronischen Getriebesteuergerät besteht. Das elektronische Getriebesteuergerät bildet aus Eingangsgrößen die für die Steuerung des Automatgetriebes erforderlichen Parameter. Eingangsgröβen sind von Sensoren bereit gestellte Signale und von anderen elektronischen Steuergeräten, z. B. dem Motorsteuergerät, zur Verfügung gestellte Signale. Das elektronische Getriebesteuergerät steuert über Ausgangssignale die elektromagnetischen Stellglieder, welche sich im Hydrauliksteuergerät befinden. Über diese elektromagnetischen Stellglieder werden Schaltungen iniziiert, indem eine entsprechende Kupplungs-/Brems-Kombination ausgewählt wird. Zusätzlich wird über die elektromagnetischen Stellglieder der Druckverlauf während der Schaltung und das Druckniveau außerhalb der Schaltung gesteuert.

Das Hydrauliksteuergerät ist oftmals auf der Unterseite des Automatgetriebes montiert und besteht aus einem Ansaugschnorchel, einem Ventilgehäuse, einem Zwischenblech mit Dichtung und einer Kanalplatte, wobei die Kanalplatte und das Getriebegehäuse über zwei Flächen miteinander in Anlage gelangen.

Automatgetriebe für Kraftfahrzeuge weisen eine im allgemeinen horizontal oder vertikal in das Getriebe eingebaute elektrohydraulische Steuerung auf, die elektromechanische und elektronische Bauteile enthält, welche mit einem außerhalb des Getriebes angeordneten Kabelstrang zu verbinden sind, beispielsweise zur Spannungsversorgung. Beispielsweise beschreibt die DE 43 44 584 C2 eine Anordnung von Magnetventilen, einem Zentralstecker und einer Leiterplatte an einem hydraulischen Getriebesteuergerät. Die elektrischen Leitungen in der Nähe des Elektronikmoduls innerhalb des Getriebes werden dabei als massive Flachleitungen in Form eines Stanzgitters oder einer flexiblen Leiterplatte ausgelegt. Diese Stanzgitter bzw. Leiterplatten werden dann mit einer Steckdose verbunden, welche im Getriebegehäuse angeordnet ist, wonach durch Einstecken eines Gegensteckers die elektrische Verbindung zum Fahrzeugkabelstrang hergestellt wird.

Bekannt sind auch Automatgetriebe, bei denen eine elektronische Getriebesteuerung im Getriebe integriert und unmittelbar an der hydraulischen Steuerung angeordnet ist.

Um eine Steckdose in Horizontalrichtung in einer Aussparung einer senkrechten Wand eines Getriebegehäuses zu ermöglichen, wurde bereits in der DE 199 22 819.1 der Anmelderin vorgeschlagen, das Stanzgitter in ebener, d. h. zweidimensionaler Anordnung, herzustellen und nach Einbringung in den Modulträger, z. B. durch Umspritzen oder Clipsen mit den einzelnen Elektro- und Elektronikbauteilen durch Löten, Schweißen oder Nieten zu verbinden. Danach wird die Steckdose in vertikaler Lage, d. h. mit nach unten gerichteter Steckeröffnung, mit dem Stanzgitter verbunden, wobei nach erfolgter Kontaktierung ein Ende des Stanzgitters zusammen mit der Steckdose entsprechend der Einbaulage um etwa 90° abgewinkelt wird, so dass die Getriebesteckdose in eine horizontale Lage gelangt. Danach wird die Steckdose so weit gegenüber ihrer endgültigen Position zurückgefahren, dass beim vertikalen Einfahren der elektrohydraulischen Steuerung die Steckdose nicht an der Innenwand des Getriebegehäuses streift. Nach erfolgter Montage der Steuerung befindet sich die Steckdose in Verlängerung der Einbaulage hinter der Einbauöffnung im Getriebegehäuse.

In der DE 199 03 712 wurde bereits ein elektrischer Steckverbinder zum Erstellen einer elektrischen Verbindung zwischen zwei durch eine Wand voneinander getrennten elektrischen Bereichen zum Einsatz in Getriebesteuersystemen in Kraftfahrzeugen vorgeschlagen, mit einem elektrische Steckkontakte tragenden ersten Steckverbindungsteil, einem elektrischen Kontaktbuchsen enthaltenden zweiten Steckverbindungsteil und einer zum Durchgreifen durch eine in einer Wand befindliche Montageöffnung ausgelegte Führungshülse, an deren einem Ende das erste Steckverbindungsteil und an deren anderem Ende das zweite Steckverbindungsteil angeordnet sind, wobei Mittel zu einer Fixierung an der Wand vorgesehen sind. Die Verbindungsmittel zum Verbinden der durch die Wand durchgreifenden Führungshülse mit dem dahinter befindlichen Steckverbindungsteil kann als Art eines Gewindes oder nach Art einer Bajonettverriegelung ausgebildet sein. Die elektrische Verbindung zwischen dem nicht zugänglichen Steckverbindungsteil, welches beispielsweise das mit einem Stiftgehäuse versehene Steckerteil ist und den elektrischen und/oder elektronischen Komponenten, die auf einem von dem Steckverbindungsteil beabstandeten Schaltungsträger angeordnet sind, kann durch flexible Leiter, beispielsweise Folienleiter, verwirklicht werden.

Bei all diesen bekannten elektrischen Steckverbindungen sind die Steckdosen bzw. die als Gegenstecker dienenden Steckerteile im Getriebegehäuse angeordnet. Bei neueren Getrieben, wie sie derzeitig entwickelt werden, besteht jedoch die Möglichkeit einer Montage eines Teils der elektrischen Steckverbindung im Getriebegehäuse als Mechatronik-Lösung nicht mehr.

Aufgabe der vorliegenden Erfindung ist es, eine elektrische Steckverbindung für das Automatgetriebe eines Kraftfahrzeugs zu schaffen, bei der trotz der bauraumbedingten Nachteile moderner Getriebe eine zuverlässige sichere und eine automatische Verbindung ermöglicht wird.

Ausgehend von einem Automatgetriebe der eingangs näher genannten Art erfolgt die Lösung dieser Aufgabe mit den im Anspruch 1 angegebenen Merkmalen; ein vorteilhaftes Ausführungsbeispiel ist im Unteranspruch beschrieben.

Erfindungsgemäß ist also vorgesehen, dass die elektrische Steckverbindung, die aus einer fest am Getriebe angeordneten Getriebesteckdose besteht, die elektrisch mit dem elektrohydraulischen Schaltgerät verbunden ist und aus einem in diese eingreifenden Steckerteil besteht, das elektrisch mit dem Fahrzeugkabelbaum verbunden ist, derart ausgestaltet ist, dass die Steckdose in der Ölwanne des Getriebes eingesetzt ist; beim Zusammenbau von Ölwanne und Getriebegehäuse eine automatische elektrische Kontaktierung bzw. beim Auseinanderbau eine automatische elektrische Trennung. Über den Fahrzeugkabelbaum wird das elektrohydraulische Getriebesteuergerät beispielsweise mit der Bordnetzspannung versorgt und/oder mit anderen elektronischen Steuergeräten verbunden.

Im Falle einer aus Kunststoff bestehenden Ölwanne ist es besonders vorteilhaft, wenn die Steckdose durch Einspritzen während des Herstellens mit der Ölwanne fest verbunden wird.

Durch die feste Montage der Getriebesteckdose (bzw. des Getriebesteckers) in der Ölwanne entfällt eine nachträgliche Montage der Steckverbindung in der Ölwanne, die aufgrund von Dichtigkeitsproblemen bzw. dem engen Bauraum äußerst ungünstig wäre. Auch eine Anbindung über einen Kabelbaum, der aus Kostengründen äußerst problematisch ist, entfällt dadurch, wobei auch die Ölwanne im demontierten Zustand nicht am Getriebestecker hängt, wie dies bei Verwendung eines Kabelbaums der Fall wäre.

Im folgenden wird die Erfindung anhand der Zeichnung näher erläutert, in der zwei vorteilhafte Ausführungsbeispiele dargestellt sind.
Es zeigen:
- Fig. 1: einen Teilschnitt durch ein Automatgetriebe mit einer erfindungsgemäß angeordneten elektrischen Steckdose und
- Fig. 2: einen Teilschnitt durch ein anderes Automatgetriebe, ebenfalls mit einer erfindungsgemäß eingesetzten Steckdose.

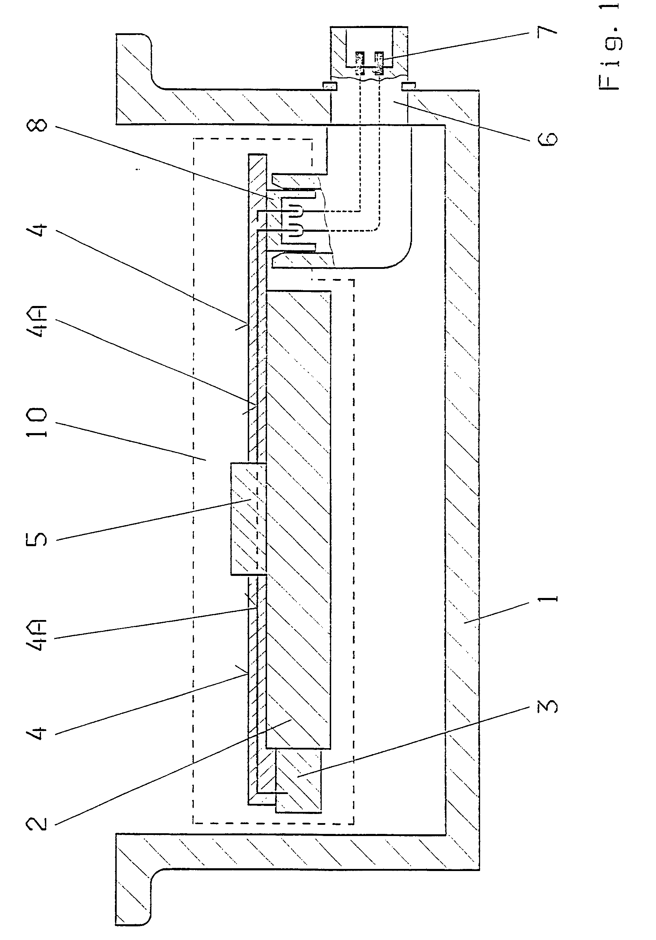

In den Figuren sind nur die für das Verständnis der Erfindung wesentlichen Bauteile dargestellt. Bei dem in Figur 1 dargestellten Teilschnitt durch ein Automatgetriebe für ein Kraftfahrzeug ist mit 1 die Ölwanne für das Getriebe bezeichnet, die bei diesem Ausführungsbeispiel in herkömmlicher Weise aus Blech besteht. Mit 10 ist ein elektrohydraulisches Getriebesteuergerät bezeichnet, welches in der dargestellten Ausgestaltung ein hydraulisches Schaltgerät 2, einen oder mehrere Aktuatoren 3, beispielsweise Druckregler oder Magnetventile, ein herkömmliches Stanzgitter oder eine flexible Leiterplatte 4, ein elektronisches Steuergerät 5 und einen elektrischer Anschluß 8 aufweist, wobei letzterer beispielsweise am hydraulischen Schaltgerät 5 vorgesehen ist. In einer anderen Ausbildung der elektrohydraulischen Steuerung 10 kann auch vorgesehen sein, daß das elektronische Steuergerät 5 außerhalb des Getriebes im Fahrzeug angeordnet ist.

Erfindungsgemäß ist nun in die Ölwanne 1 eine Steckdose 6 als Teil einer elektrischen Steckverbindung zwischen dem elektrohydraulischen Getriebesteuergerät 10 bzw. dem elektronischen Steuergerät 5 und einem (nicht dargestellten) Fahrzeugkabelbaum vorgesehen, wobei mit 7 ein elektrischer Kontakt angedeutet ist. Die feste Montage einer Steckdose 6 an der Ölwanne 1 an einer geeigneten Stelle ermöglicht die automatische Kontaktierung mittels des Anschlusses 8 des elektrischen Leiters bei Montage der Ölwanne bzw. ein automatisches Lösen der elektrischen Verbindung bei Demontage der Ölwanne.

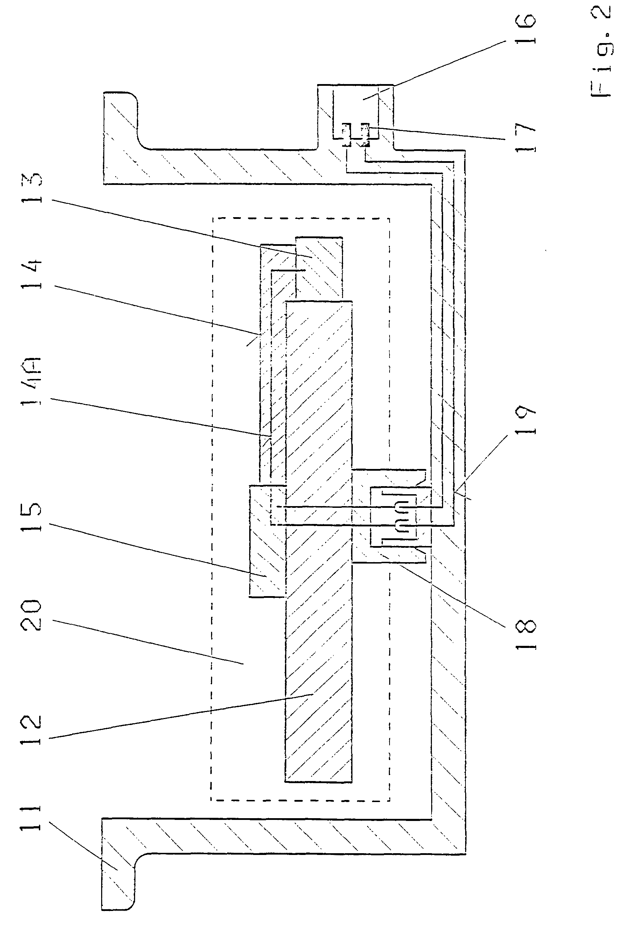

Bei dem in Fig. 2 dargestellten Teilschnitt durch ein Automatgetriebe ist mit 11 eine Ölwanne aus Kunststoff bezeichnet, mit 20 wieder das elektrohydraulische Schaltgerät, welches ein hydraulisches Steuergerät 12, einen oder mehreren Aktuatoren 13, ein Stanzgitter oder eine flexible Leiterplatte 14 mit elektrischen Leitern 14A, ein elektronisches Getriebesteuergerät 15 und eine erfindungsgemäß in die Ölwanne 11 eingesetzte Steckdose 16 mit einem elektrischen Anschluß 17 aufweist. Die Steckdose 16 ist bei diesem Ausführungsbeispiel vorteilhafterweise bei der Herstellung der Ölwanne 11 bereits durch einen Spitzvorgang in diese eingesetzt. Mit 18 ist wieder ein elektrischer Anschluß bezeichnet zwischen dem elektrischen Leiter 19, der von der Steckdose 16 kommt, zum hydraulischen Schaltgerät 12 und der den elektrischen Anschluß automatisch herstellt, wenn die Ölwanne 11 am Getriebe montiert wird. Der elektrische Leiter 19 kann bereits bei der Herstellung in die Wand der Ölwanne 11 integriert werden oder aber auf deren Innenseite angeordnet werden.

Die elektrische Verbindung zwischen dem elektrohydraulischen Schaltgerät 20 bzw. dem elektronischen Steuergerät 15 und dem (nicht dargestellten) Fahrzeugkabelbaum wird durch Eingreifen eines (nicht dargestellten) Steckerteils in die Ölwanne 1 bzw. 11 eingesetzte Steckdose 6 bzw. 16 hergestellt.

### Bezugszeichen

- 1: Ölwanne
- 2: hydraulisches Schaltgerät
- 3: Aktuator
- 4: Stanzgitter
- 4A: Leiter
- 5: elektronisches Steuergerät
- 6: Steckdose
- 7: Kontakt
- 8: Anschluß
- 9: -
- 10: elektrohydraulisches Getriebesteuergerät
- 11: Ölwanne
- 12: hydraulisches Schaltgerät
- 13: Aktuator
- 14: Stanzgitter
- 14A: Leiter
- 15: elektronisches Steuergerät
- 16: Steckdose
- 17: Kontakt
- 18: Anschluß
- 19: Leiter
- 20: elektrohydraulisches Getriebesteuergerät

## Patentansprüche

1. Automatgetriebe eines Kraftfahrzeuges mit einer elektrischen Steckverbindung zur Übertragung von zur Steuerung eines elektrohydraulischen Steuergeräts (10, 20) erforderlichen Signalen von außerhalb des Getriebes angeordneten Signalquellen an das elektrohydraulische Steuergerät (10, 20), wobei die elektrische Steckverbindung aus einer fest am Automatgetriebe angeordneten Steckdose (6, 16) besteht, die elektrisch mit dem elektrohydraulischen Schaltgerät (10, 20) verbunden ist und aus einem in diese eingreifenden Steckerteil besteht, das elektrisch mit den außerhalb des Getriebes angeordneten Signalquellen verbunden ist, **dadurch gekennzeichnet, dass** die Steckdose (6, 16) in einer Ölwanne (1, 11) des Automatgetriebes eingesetzt ist und dass beim Zusammenbau der Ö1-wanne (1, 11) an ein Getriebegehäuse des Automatgetriebes eine automatische elektrische Kontaktierung zwischen Steckdose (6, 16) und elektrohydraulischem Steuergerät (10, 20) über einen Anschluß (8, 18) erfolgt bzw. beim Auseinanderbau von Ölwanne (1, 11) und Getriebegehäuse eine automatische elektrische Trennung erfolgt.

2. Automatgetriebe nach Anspruch 1, **dadurch gekennzeichnet, dass** bei Verwendung einer aus Kunststoff bestehenden Ölwanne (11) die Steckdose (16) durch ein Einspritzen während des Herstellens mit dieser fest verbunden wird.

## Claims

1. Automatic transmission of a motor vehicle with an electrical plug-and-socket connection for the transmission to an electrohydraulic control device (10, 20) of signals received from transmission-external sources and required for controlling the electrohydraulic control device (10, 20), with the electrical plug-in connection consisting of a receptacle (6, 16), which is fixed to the automatic transmission and which is electrically connected to the electrohydraulic control unit (10, 20), and of an engaging plug, which is electrically connected to the signal sources located outside the transmission, **characterized in that** the receptacle (6, 16) is located in an oil sump (1, 11) of the automatic transmission. When the oil sump (1, 11) and the transmission housing of the automatic transmission are assembled, an electrical contact between the receptacle (6, 16) and the electrohydraulic control unit (10, 20) is automatically established via a connector (8, 18); when oil sump (1, 11) and transmission housing are disassembled, this electrical connection is automatically separated.

2. Automatic transmission according to claim 1, **characterized in that** if a plastic oil sump (11) is used, the receptacle (16) is firmly connected to it by means of injection during the manufacturing process.

## Revendications

1. Transmission automatique d'un véhicule automobile comprenant une connexion électrique à broches pour transmettre des signaux nécessaires pour la commande d'un appareil de commande électrohydraulique (10, 20) en provenance de sources de signaux disposées en dehors de la transmission à l'appareil de commande électro-hydraulique (10, 20), dans laquelle la connexion électrique à broches est composée d'un socle de prise (6, 16) monté rigidement sur la transmission automatique, qui est connecté électriquement à l'appareil de commande électrohydraulique (10, 20), et d'une fiche mâle qui s'embroche dans ce socle, qui est connectée électriquement aux sources de signaux disposées à l'extérieur de la transmission, **caractérisée en ce que** le socle (6, 16) est encastré dans un bac d'huile (1, 11) de la transmission automatique et **en ce que**, lorsqu'on assemble le bac d'huile (1, 11) à un carter de la transmission automatique, il se produit une mise en contact électrique automatique entre le socle (6, 16) et l'appareil de commande électrohydraulique (10, 20) par l'intermédiaire d'un raccordement (8, 18) et que, lorsqu'on sépare le bac d'huile (1, 11) du carter de la transmission, il se produit une déconnexion électrique automatique.

2. Transmission automatique selon la revendication 1, **caractérisée en ce que**, dans le cas de l'utilisation d'un bac d'huile (11) en matière plastique, le socle de prise (16) est relié rigidement à ce bac par injection pendant la fabrication.
